# EUROPÄISCHE PATENTSCHRIFT

(11) **EP 0 391 126 B1**
(45) Veröffentlichungstag und Bekanntmachung des Hinweises auf die Patenterteilung: **09.03.1994**
(21) Anmeldenummer: 90105255.5
(22) Anmeldetag: 20.03.1990
(51) Int. Cl.: H03K 17/955, H03K 17/975

(54) **Elektronischen Annäherungsschalter**
Electronic proximity switch
Initiateur électronique d'approche

(30) Priorität: 05.04.1989 DE 3911009
(43) Veröffentlichungstag der Anmeldung: 10.10.1990
(73) Patentinhaber: i f m electronic gmbh, D-45127 Essen (DE)
(72) Erfinder: Hantsche, Gerhardt, 7992 Tettnang 1 (DE)
(74) Vertreter: Gesthuysen, Hans Dieter, Dipl.-Ing.

(56) Entgegenhaltungen:
- DE-A- 2 744 785
- Grunglagen der Elektronik, Albrecht Rost, Springer Verlag 1983, Seiten 60-65
- Knaurs Lexikon der Technik, Droemer Knaur "Schwingkreis" Band 2 (Kos-Z) 1988 Seiten 874-875
- Das grosse Werkbuch der Elektronik, Dieter Nührmann "Grundlagen der L-C-Abstimmung" Franzis Verlag 1989, Seite 2154

## Beschreibung

Die Erfindung betrifft einen elektronischen Annäherungsschalter mit einem von außen kapazitiv beeinflußbaren Oszillator, wobei zu dem Oszillator eine gegenüber Masse kapazitiv wirkende Ansprechelektrode und eine auf einem Bezugspotential, insbesondere auf Massepotential, liegende, der Ansprechelektrode einseitig zugewandte Abschirmelektrode gehört und eine Änderung der Kapazität zwischen der Ansprechelektrode und Masse eine Änderung der Amplitude der Oszillatorschwingung bewirkt.

Elektronische Annäherungsschalter der zuvor beschriebenen Art, sogenannte kapazitive Annäherungsschalter, sind seit langem bekannt (DE-B 2 744 785). Kapazitive Annäherungsschalter weisen neben dem Oszillator ggf. noch einen Schaltverstärker und ggf. noch eine Speiseschaltung zur Erzeugung der Speisespannung für den Oszillator und für den ggf. vorhandenen Schaltverstärker auf. Im Rahmen der Erfindung kommt es aber auf diese weiteren Ausgestaltungsdetails von kapazitiven Annäherungsschaltern nicht an, so daß es sich erübrigt, insoweit auf Einzelheiten einzugehen.

Der bekannte kapazitive Annäherungsschalter, von dem die Erfindung ausgeht (DE-B 2 744 785) weist neben der einen auf Massepotential liegenden Abschirmelektrode, der sogenannten Masseelektrode, noch eine weitere, zwischen der Ansprechelektrode und der Masseelektrode angeordnete, auf einem bestimmten Bezugspotential liegende Abschirmelektrode auf, deren Potential durch eine bestimmte elektronische Schaltung dem Potential der Ansprechelektrode nach Betrag und Phase stets folgt. Dadurch werden verschiedene schaltungstechnische Vorteile erzielt. Da es aber auch darauf im Rahmen der Erfindung nicht weiter ankommt, erübrigt es sich auch hier, auf weitere Einzelheiten einzugehen.

Der bekannte kapazitive Annäherungsschalter, von dem die Erfindung ausgeht, weist im übrigen ein zylindrisches Gehäuse auf, in dem die Ansprechelektrode an der Stirnseite angeordnet und scheibenförmig ausgeführt ist. Die Abschirmelektroden sind koaxial zur Ansprechelektrode angeordnet, axial gesehen aber hinter der Ansprechelektrode positioniert.

Im Rahmen der Erfindung wesentlich ist nun, wie im Stand der Technik, von dem die Erfindung ausgeht, der Schaltabstand bzw. die Empfindlichkeit des kapazitiven Annäherungsschalters eingestellt wird. Dies erfolgt bei kapazitiven Annäherungsschaltern ganz generell durch Einstellung eines elektronischen Bauelements, das Teil der Oszillatorschaltung ist, bei dem Stand der Technik, von dem die Erfindung ausgeht, durch Einstellung des Emitterwiderstands eines als Emitterfolger geschalteten Oszillatortransistors, wodurch der Verstärkungsfaktor des Oszillatorschaltkreises beeinflußt wird.

Der Oszillator des bekannten kapazitiven Annäherungsschalters ist relativ teuer, insbesondere bei sehr kleinen Außenabmessungen des kapazitiven Annäherungsschalters, und zwar wegen des hohen Preises sehr kleiner, gleichwohl aber mechanisch einstellbarer elektronischer Bauelemente.

Die Erfindung stellt sich folglich die Aufgabe, den bekannten kapazitiven Annäherungsschalter so auszugestalten und weiterzubilden, daß er, insbesondere unter Berücksichtigung besonders kleiner Außenabmessungen, preiswerter hergestellt werden kann.

Die zuvor aufgezeigte Aufgabe ist dadurch gelöst, daß die Kapazität des von der Ansprechelektrode und der Abschirmelektrode gebildeten Kondensators mechanisch verstellbar ist. Erfindungsgemäß wird also im Oszillatorschaltkreis hinsichtlich der Einstellung des Schaltabstandes bzw. der Empfindlichkeit auf einstellbare elektronische Bauelemente verzichtet. Die Einstellung des Schaltabstandes bzw. der Empfindlichkeit des kapazitiven Annäherungsschalters erfolgt hier vielmehr mechanisch, nämlich durch mechanische Einstellung der Kapazität des von der Ansprechelektrode und der Abschirmelektrode gebildeten Kondensators. Erkannt worden ist, daß mit der Kapazität dieses Kondensators eine mechanisch beeinflußbare elektrische Größe des Oszillatorschaltkreises existiert, deren Beeinflussung herstellungstechnisch erheblich preiswerter möglich ist als die aus dem Stand der Technik bekannte elektronische Lösung.

Es gibt nun verschiedene Möglichkeiten, die Lehre der Erfindung auszugestalten und weiterzubilden, wozu einerseits auf die dem Anspruch 1 nachgeordneten Ansprüche, andererseits auf die Erläuterung eines bevorzugten Ausführungsbeispiels anhand der Zeichnung verwiesen werden darf.

In der Zeichnung zeigt
- Fig. 1: schematisch, in einer Seitenansicht, ein bevorzugtes Ausführungsbeispiel eines erfindungsgemäßen kapazitiven Annäherungsschalters,
- Fig. 2: das elektrische Ersatzschaltbild für den von der Ansprechelektrode und der Abschirmelektrode gebildeten Kondensator und
- Fig. 3: verschiedene Querschnittsformen einer beim kapazitiven Annäherungsschalter aus Fig. 1 verwirklichten Einstellelektrode.

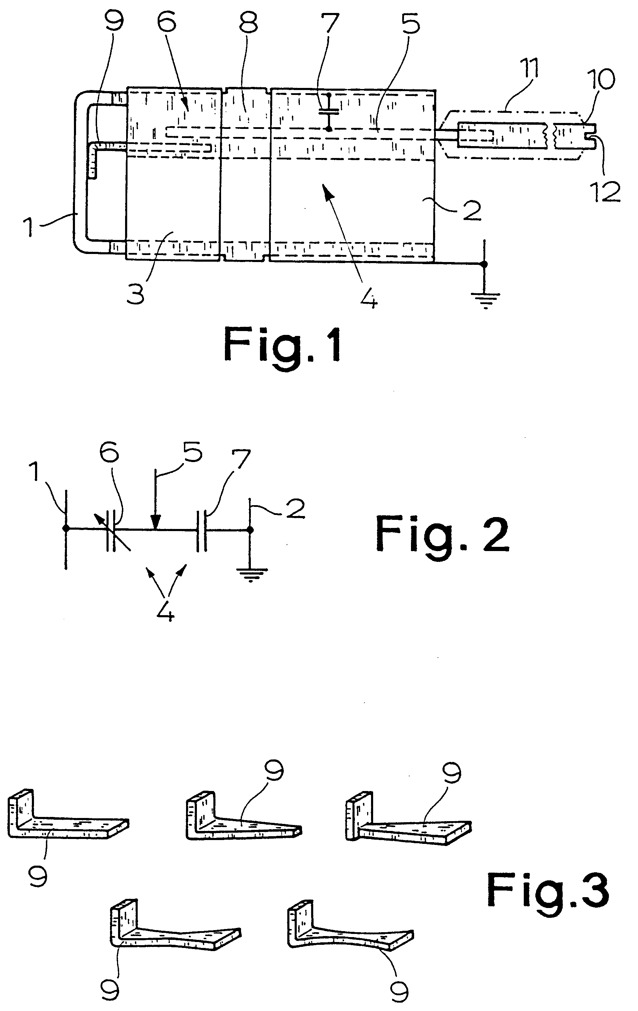

Der in Fig. 1 dargestellte elektronische Annäherungsschalter ist ein kapazitiver Annäherungsschalter, weist also einen von außen kapazitiv beeinflußbaren Oszillator auf. Zu dem Oszillator gehört eine kapazitiv wirkende Ansprechelektrode 1 und eine auf einem Bezugspotential, hier und insbesondere auf Massepotential liegende, der Ansprechelektrode 1 zugeordnete Abschirmelektrode 2. Eine Änderung der Kapazität zwischen der Ansprechelektrode 1 und Masse bewirkt eine Änderung der Amplitude der Oszillatorschwingung. Dargestellt ist in Fig. 1 insoweit eine besonders bevorzugte Ausführungsform eines solchen kapazitiven Annäherungsschalters, als noch eine weitere Abschirmelektrode 3, die ebenfalls auf einem bestimmten Bezugspotential liegt, vorgesehen ist. Für die Lehre der Erfindung wesentlich ist aber die Relation der Ansprechelektrode 1 zur Abschirmelektrode 2.

Wesentlich ist nun, daß die Kapazität des von der Ansprechelektrode 1 und der Abschirmelektrode 2 gebildeten Kondensators 4 mechanisch einstellbar ist. Der Kondensator 4 ist in Fig. 2 im Ersatzschaltbild gut verständlich dargestellt. Die Kapazität des Kondensators 4 hängt einerseits von seinem geometrischen Aufbau, andererseits vom verwendeten Dielektrikum ab. Der geometrische Aufbau, insbesondere also Abstand der beiden flächenhaften Leiter, der Belegungen, und Fläche der Belegungen, wird erfindungsgemäß zur Einstellung des Schaltabstands bzw. der Empfindlichkeit des kapazitiven Annäherungsschalters genutzt.

Sehr einfach läßt sich die Kapazität des Kondensators dadurch beeinflussen, daß der Abstand der Abschirmelektrode von der Ansprechelektrode verstellbar ist. Im hier dargestellten Ausführungsbeispiel ist alternativ allerdings realisiert, daß die wirksame Belegungsfläche des Kondensators 4 verstellbar ist. Aus dem Bereich der Kondensatoren mit verstellbarer Kapazität, insbesondere der Trimmer, sind Beispiele bekannt, wie man verstellbare Belegungsflächen eines Kondensators realisieren kann.

Im hier dargestellten und insoweit bevorzugten Ausführungsbeispiel ist eine sehr einfache und damit preiswert herzustellende Lösung für eine verstellbare Belegungsfläche des Kondensators 4 realisiert worden. Und zwar ist dies dadurch realisiert worden, daß zwischen der Ansprechelektrode 1 und der Abschirmelektrode 2 eine verstellbare Zwischenelektrode 5 potentialfrei angeordnet und so gegenüber der Ansprechelektrode 1 ein Ansprechkondensator 6 und gegenüber der Abschirmelektrode 2 ein Abschirmkondensator 7 gebildet ist. Fig. 1 zeigt den hier verwirklichten mechanischen Aufbau, wobei der natürlich nur elektrisch vorhandene Abschirmkondensator 7 hier mit eingezeichnet ist. Die entsprechende schaltungstechnische Darstellung in Form eines Ersatzschaltbildes zeigt Fig. 2. Wesentlich ist, daß mit der auf floatendem Potential befindlichen Zwischenelektrode 5 ein verstellbares Bauelement eingeführt worden ist, das die sonst erforderliche Geometrie des kapazitiven Annäherungsschalters unangetastet läßt, gleichzeitig aber die gewünschte Verstellbarkeit in mechanischer Hinsicht ermöglicht.

Im hier dargestellten und bevorzugten Ausführungsbeispiel gilt nun, daß bei Verstellung der Zwischenelektrode 5 Abstand und Belegungsfläche der Zwischenelektrode 5 gegenüber der Abschirmelektrode 2, also die Kapazität des Abschirmkondensators 7, unverändert bleiben, Abstand und/oder Belegungsfläche der Zwischenelektrode 5 gegenüber der Ansprechelektrode 1, also die Kapazität des Ansprechkondensators 6, aber verstellbar sind. Damit wird also die Verstellbarkeit der Kapazität des Kondensators 4 allein durch die Verstellbarkeit der Kapazität des Ansprechkondensators 6 realisiert.

Zuvor ist schon gesagt worden, daß die Kapazität des Kondensators 4 auch durch die Art des Dielektrikums beeinflußt wird. Im dargestellten Ausführungsbeispiel gilt nun, daß zwischen der Ansprechelektrode 1 oder einem Teil der Ansprechelektrode 1 und der Abschirmelektrode 2 ein festes Dielektrikum 8, insbesondere eine Kunststoffüllung, angeordnet ist und daß die Zwischenelektrode 5 in dem Dielektrikum 8 mechanisch verstellbar angeordnet ist. Dabei ist erkannt worden, daß ein festes Dielektrikum 8 gleichzeitig auf sehr einfache Art eine sichere und genaue Führung der Zwischenelektrode 5 ergibt. Gerade bei kapazitiven Annäherungsschaltern mit sehr kleinen Außenabmessungen läßt sich dies vorteilhaft einsetzen.

Zuvor ist schon der mechanisch-konstruktive Aufbau des im dargestellten Ausführungsbeispiel verwirklichten kapazitiven Annäherungsschalters erläutert worden. In Ansehung dieses mechanisch-konstruktiven Aufbaus, insbesondere in Ansehung der Anordnung der Abschirmelektrode 2, empfiehlt es sich, daß die Zwischenelektrode 5 als sich parallel zur Abschirmelektrode 2 bzw. axial durch die Abschirmelektrode 2 hindurch bis an die Ansprechelektrode 1 heran erstreckende Metallstange oder -platte ausgeführt und in axialer Richtung verstellbar ist. Dann, wenn sich, eine Ringelektrode als Abschirmelektrode 2 vorausgesetzt, die Zwischenelektrode 5 wirklich in allen möglichen Positionen vollständig durch die Abschirmelektrode 2 hindurch erstreckt, ist damit auf sehr einfache Weise die Bedingung realisiert, daß sich die Kapazität des Abschirmkondensators 7 bei Verstellung der Zwischenelektrode 5 nicht ändert. Gleichwohl ist auf ebenso einfache Art dann realisiert, daß sich die Änderung der Kapazität des Kondensators 4 insgesamt nur in der Änderung der Kapazität des Ansprechkondensators 6 niederschlägt.

Schon durch die reine axiale Verstellung der als Metallstange oder Metallplatte ausgeführten Zwischenelektrode 5 in Fig. 1 würde eine Änderung der Kapazität des Ansprechkondensators 6 eintreten. Um quantitativ einen stärkeren Einfluß zu bekommen, ist aber im dargestellten Ausführungsbeispiel realisiert, daß eine axiale Verstellung der Zwischenelektrode 5 auch eine Änderung der Belegungsflächen mit sich bringt. Konstruktiv besonders einfach ist die dargestellte Lösung, die dadurch gekennzeichnet ist, daß die Ansprechelektrode 1 auf der Rückseite eine axial abragende, sich in einem bestimmten Abstand parallel zur Zwischenelektrode 5 erstreckende, metallische Einstellelektrode 9 aufweist und der einstellbare Ansprechkondensator 6 von der Zwischenelektrode 5 und der Einstellelektrode 9 gebildet ist. Im dargestellten Ausführungsbeispiel gilt überdies, daß die Einstellelektrode 9 in das feste Dielektrikum 8 hineingeführt und darin jedenfalls insoweit eingebettet ist, als sie mit der Zwischenelektrode 5 gemeinsam den Ansprechkondensator 6 bildet.

Eine spezielle Einstellcharakteristik für den Schaltabstand bzw. die Empfindlichkeit ist natürlich schon allein durch die wegabhängige Größe der Kapazität des Ansprechkondensators 6 gegeben. Weitere besondere Charakteristika lassen sich dadurch erzielen, daß die Einstellelektrode 9 und/oder die Zwischenelektrode 5 quer zur Verstellrichtung gesehen einen sich in Verstellrichtung ändernden Querschnitt aufweist, was beispielhaft in Fig. 3 dargestellt ist.

Um schließlich sicherzustellen, daß die Zwischenelektrode 5 wirklich potentialfrei ist, also auf floatendem Potential liegt, läuft im dargestellten Ausführungsbeispiel das Ende der Zwischenelektrode 5 in einer Kunststoff-Gewindestange 10 aus. Diese befindet sich in einer hier strichpunktiert dargestellten Abdichtung 11 und weist am Ende einen Schraubendreherschlitz 12 auf.

Abgesehen von den erheblich geringeren Kosten gerade bei besonders kleinen kapazitiven Annäherungsschaltern führt die mechanische Einstellbarkeit des Schaltabstandes bzw. der Empfindlichkeit noch zu weiteren Vorteilen. So wird das Vergießen des elektronischen Annäherungsschalters sehr viel einfacher, besondere Dichtigkeitsanforderungen können leichter erfüllt werden, die Steuerung erfolgt kontakt- und leitungsfrei, also ohne zusätzliche Leitungen und die Einstellung ist sehr empfindlich möglich. Bereits mit einer veränderbaren Kapazität von 0,5 pF läßt sich der Schaltabstand im Verhältnis von 1 : 50, beispielsweise also von 2 bis 100 mm verändern.

## Patentansprüche

1. Elektronischer Annäherungsschalter mit einem von außen kapazitiv beeinflußbaren Oszillator, wobei zu dem Oszillator eine gegenüber Masse kapazitiv wirkende Ansprechelektrode (1) und eine auf einem Bezugspotential, insbesondere auf Massepotential, liegende, der Ansprechelektrode einseitig zugewandte Abschirmelektrode (2,3) gehört und eine Änderung der Kapazität zwischen der Ansprechelektrode und Masse eine Änderung der Amplitude der Oszillatorschwingung bewirkt, **dadurch gekennzeichnet**, daß die Kapazität des von der Ansprechelektrode (1) und der Abschirmelektrode (2) gebildeten Kondensators (4) mechanisch verstellbar ist.

2. Annäherungsschalter nach Anspruch 1, dadurch gekennzeichnet, daß der Abstand der Abschirmelektrode von der Ansprechelektrode verstellbar ist.

3. Annäherungsschalter nach Anspruch 1 oder 2, dadurch gekennzeichnet, daß die wirksame Belegungsfläche des von der Ansprechelektrode und der Abschirmelektrode gebildeten Kondensators (4) verstellbar ist.

4. Annäherungsschalter nach einem der Ansprüche 1 bis 3, dadurch gekennzeichnet, daß zwischen der Ansprechelektrode (1) und der Abschirmelektrode (2) eine verstellbare Zwischenelektrode (5) potentialfrei angeordnet und so gegenüber der Ansprechelektrode (1) ein Ansprechkondensator (6) und gegenüber der Abschirmelektrode (2) ein Abschirmkondensator (7) gebildet ist.

5. Annäherungsschalter nach Anspruch 4, dadurch gekennzeichnet, daß bei Verstellung der Zwischenelektrode (5) Abstand und Belegungsfläche der Zwischenelektrode (5) gegenüber der Abschirmelektrode (2), also die Kapazität des Abschirmkondensators (7), unverändert bleiben, Abstand und/oder Belegungsfläche der Zwischenelektrode (5) gegenüber der Ansprechelektrode (1), also die Kapazität des Ansprechkondensators (6), aber verstellbar sind.

6. Annäherungsschalter nach Anspruch 4 oder 5, dadurch gekennzeichnet, daß zwischen der Ansprechelektrode (1) oder einem Teil der Ansprechelektrode (1) und der Abschirmelektrode (2) ein festes Dielektrikum (8), insbesondere eine Kunststoffüllung, angeordnet ist und daß die Zwischenelektrode (5) in dem Dielektrikum (8) mechanisch verstellbar angeordnet ist.

7. Annäherungsschalter nach einem der Ansprüche 4 bis 6, wobei der Oszillator in einem zylindrischen Gehäuse angeordnet ist, die Ansprechelektrode an der Stirnseite des Gehäuses angeordnet ist und die Abschirmelektrode axial gesehen hinter der Ansprechelektrode angeordnet und, vorzugsweise, als Ringelektrode ausgeführt ist, dadurch gekennzeichnet, daß die Zwischenelektrode (5) als sich parallel zur Abschirmelektrode (2) bzw. axial durch die Abschirmelektrode (2) hindurch bis an die Ansprechelektrode (1) heran erstreckende Metallstange oder -platte ausgeführt und in axialer Richtung verstellbar ist.

8. Annäherungsschalter nach Anspruch 7, dadurch gekennzeichnet, daß die Ansprechelektrode (1) auf der Rückseite eine axial abragende, sich in einem bestimmten Abstand parallel zur Zwischenelektrode (5) erstreckende, metallische Einstellelektrode (9) aufweist und der einstellbare Ansprechkondensator (6) von der Zwischenelektrode (5) und der Einstellelektrode (9) gebildet ist.

9. Annäherungsschalter nach Anspruch 8, dadurch gekennzeichnet, daß die Einstellelektrode (9) in das feste Dielektrikum (8) hineingeführt und darin jedenfalls insoweit eingebettet ist, als sie mit der Zwischenelektrode (5) gemeinsam den Ansprechkondensator (6) bildet.

10. Annäherungsschalter nach Anspruch 8 oder 9, dadurch gekennzeichnet, daß die Einstellelektrode (9) und/oder die Zwischenelektrode (5) quer zur Verstellrichtung gesehen einen sich in Verstellrichtung ändernden Querschnitt aufweist.

11. Annäherungsschalter nach einem der Ansprüche 4 bis 10, dadurch gekennzeichnet, daß das Ende der Zwischenelektrode (5) in einer Kunststoff-Gewindestange (10) od. dgl. ausläuft.

## Claims

1. An electronic proximity switch with an externally capacitively influenceable oscillator, wherein a response electrode (1), which acts capacitively with respect to earth, and a screening electrode (2, 3), one side of which faces the response electrode and which is at a reference potential, particularly earth potential, form part of the oscillator, and a change in the capacitance between the response electrode and earth causes a change in amplitude of the oscillator vibration, characterised in that the capacitance of the capacitor (4) formed by the response electrode (1) and the screening electrode (2) can be adjusted mechanically.

2. A proximity switch according to claim 1, characterised in that the distance of the screening electrode from the response electrode is adjustable.

3. A proximity switch according to claim 1 or 2, characterised in that the effective charge accumulation area of the capacitor (4) formed by the response electrode and the screening electrode is adjustable.

4. A proximity switch according to any one of claims 1 to 3, characterised in that an adjustable intermediate electrode (5) is disposed free from potential between the response electrode (1) and the screening electrode (2) and thus a response capacitor (6) is formed with respect to the response electrode (1) and a screening capacitor (7) is formed with respect to the screening electrode (2).

5. A proximity switch according to claim 4, characterised in that on adjusting the intermediate electrode (5) the spacing and charge accumulation area of the intermediate electrode (5) with respect to the screening electrode (2), and therefore the capacitance of the screening capacitor (7), remain constant, but that the spacing and/or charge accumulation area of the intermediate electrode (5) with respect to the response electrode (1), and therefore the capacitance of the response capacitor (6), are adjustable.

6. A proximity switch according to claim 4 or 5, characterised in that a solid dielectric (8), particularly a plastic filler material, is disposed between the response electrode (1) or a part of the response electrode (1) and the screening electrode (2), and that the intermediate electrode (5) is arranged so that it is mechanically adjustable within the dielectric (8).

7. A proximity switch according to any one of claims 4 to 6, wherein the oscillator is disposed in a cylindrical housing, the response electrode is disposed on the end face of the housing, and the screening electrode is disposed behind the response electrode as viewed axially and is preferably constructed as an annular electrode, characterised in that the intermediate electrode (5) is constructed as a metal rod or plate extending parallel to the screening electrode (2) or axially through the screening electrode (2) as far as the response electrode (1), and is adjustable in the axial direction.

8. A proximity switch according to claim 7, characterised in that the response electrode (1) has an axially projecting metal adjusting electrode (9) on its rear face, which extends for a certain distance parallel to the intermediate electrode (5), and the adjustable response capacitor (6) is formed from the intermediate electrode (5) and the adjusting electrode (9).

9. A proximity switch according to claim 8, characterised in that the adjusting electrode (9) is led into the solid dielectric (8) and is embedded therein at least to such an extent that it forms the response capacitor (6) jointly with the intermediate electrode (5).

10. A proximity switch according to claim 8 or 9, characterised in that the adjusting electrode (9) and/or the intermediate electrode (5) has a cross-section which, as viewed transversely to the direction of adjustment, varies in the direction of adjustment.

11. A proximity switch according to any one of claims 4 to 10, characterised in that the end of the intermediate electrode (5) terminates in a threaded plastic rod (10) or the like.

## Revendications

1. Initiateur d'approche électronique, comprenant un oscillateur dont la capacité peut être influencée par l'extérieur, à l'oscillateur étant associées une électrode de réponse (1) agissant de manière capacitive par rapport à la masse et une électrode de blindage (2, 3) présentant un potentiel de référence, et notamment le potentiel de masse, et étant dirigée unilatéralement vers l'électrode de réponse, et une variation de la capacité entre l'électrode de réponse et la masse provoquant une variation de l'amplitude de l'oscillation de l'oscillateur, **caractérisé par le fait** que la capacité du condensateur (4) formé par l'électrode de réponse (1) et l'électrode de blindage (2) peut être réglée mécaniquement.

2. Initiateur d'approche selon la revendication 1, caractérisé par le fait que la distance entre l'électrode de blindage et l'électrode de réponse est réglable.

3. Initiateur d'approche selon l'une des revendications 1 ou 2, caractérisé par le fait que la surface d'armature active du condensateur (4) formé par l'électrode de réponse et l'électrode de blindage est réglable.

4. Initiateur d'approche selon l'une des revendications 1 à 3, caractérisé par le fait qu'entre l'électrode de réponse (1) et l'électrode de blindage (2) est disposée sans potentiel une électrode intermédiaire (5) de manière à former un condensateur de réponse (6) par rapport à l'électrode de réponse (1) et un condensateur de blindage (7) par rapport à l'électrode de blindage (2).

5. Initiateur d'approche selon la revendication 4, caractérisé par le fait que, lors du déplacement de l'électrode intermédiaire (5), la distance et la surface d'armature de l'électrode intermédiaire (5) par rapport à l'électrode de blindage (2), c'est-à-dire la capacité du condensateur de blindage (7), restent inchangées, mais que la distance et/ou la surface d'armature de l'électrode intermédiaire (5) par rapport à l'électrode de réponse (1), c'est-à-dire la capacité du condensateur de réponse (6), sont réglables.

6. Initiateur d'approche selon l'une des revendications 4 ou 5, caractérisé par le fait qu'entre l'électrode de réponse (1) ou une partie de l'électrode de réponse (1) et l'électrode de blindage (2) est disposé un diélectrique solide (8), en particulier un remplissage de matière plastique, et que l'électrode intermédiaire (5) est disposée de manière à pouvoir être déplacée mécaniquement dans le diélectrique (8).

7. Initiateur d'approche selon l'une des revendications 4 à 6, l'oscillateur étant logé dans un boîtier cylindrique, l'électrode de réponse étant située sur la face frontale du boîtier et l'électrode de blindage étant disposée axialement derrière l'électrode de réponse et avantageusement conformée en électrode annulaire, caractérisé par le fait que l'électrode intermédiaire (5) est réalisée sous la forme d'une barre ou plaque métallique qui s'étend parallèlement à l'électrode de blindage (2) et respectivement axialement au travers de l'électrode de blindage (2) jusqu'à l'électrode de réponse (1) et qu'elle est déplaçable dans le sens axial.

8. Initiateur d'approche selon la revendication 7, caractérisé par le fait que l'électrode de réponse (1) présente sur la face arrière une électrode de réglage (9) métallique qui fait saillie dans le sens axial et s'étend à une certaine distance parallèlement par rapport à l'électrode intermédiaire (5), et que le condensateur de réponse (6) réglable est constitué par l'électrode intermédiaire (5) et l'électrode de réglage (9).

9. Initiateur d'approche selon la revendication 8, caractérisé par le fait que l'électrode de réglage (9) est engagée dans le diélectrique solide (8) et en tout cas encastrée dans celui-ci de telle façon qu'elle forme, conjointement avec l'électrode intermédiaire (5), le condensateur de réponse (6).

10. Initiateur d'approche selon l'une des revendications 8 ou 9, caractérisé par le fait que l'électrode de réglage (9) et/ou l'électrode intermédiaire (5) présente(nt), transversalement à la direction de déplacement, une section transversale qui varie dans ladite direction de déplacement.

11. Initiateur d'approche selon l'une des revendications 4 à 10, caractérisé par le fait que l'extrémité de l'électrode intermédiaire (5) se termine par une tige filetée (10) en matière plastique ou analogue.
